# EUROPÄISCHE PATENTSCHRIFT

(11) **EP 1 200 650 B1**
(45) Veröffentlichungstag und Bekanntmachung des Hinweises auf die Patenterteilung: **09.04.2003**
(21) Anmeldenummer: 00952899.3
(22) Anmeldetag: 04.07.2000
(51) Int. Cl.: C30B 23/00, C30B 29/36

(54) **VORRICHTUNG ZUR SUBLIMATIONSZÜCHTUNG EINES SIC-EINKRISTALLS MIT FOLIENAUSGEKLEIDETEM TIEGEL**
SIC MONOCRYSTAL SUBLIMATION GROWTH DEVICE WITH A FILM-COVERED CRUCIBLE
DISPOSITIF POUR LA PRODUCTION PAR SUBLIMATION D'UN MONOCRISTAL DE SIC A L'AIDE D'UN CREUSET REVETU D'UN FILM

(30) Priorität: 07.07.1999 DE 19931334
(43) Veröffentlichungstag der Anmeldung: 02.05.2002
(73) Patentinhaber: SIEMENS AKTIENGESELLSCHAFT, 80333 München (DE)
(72) Erfinder: STEIN, Rene, D-91341 Röttenbach (DE); KUHN, Harald, D-91056 Erlangen (DE); VÖLKL, Johannes, D-91056 Erlangen (DE)
(86) Internationale Anmeldenummer: DE0002170
(87) Internationale Veröffentlichungsnummer: WO01004389

(56) Entgegenhaltungen:
- WO-A-97/27350
- DE-A- 3 644 746
- US-A- 5 667 587
- PATENT ABSTRACTS OF JAPAN vol. 1999, no. 09, 30. Juli 1999 (1999-07-30) & JP 11 116399 A (DENSO CORP), 27. April 1999 (1999-04-27)
- MOKHOV E N ET AL: "Growth of silicon carbide bulk crystals by the sublimation sandwich method" MATERIALS SCIENCE AND ENGINEERING B,CH,ELSEVIER SEQUOIA, LAUSANNE, Bd. 46, Nr. 1-3, 1. April 1997 (1997-04-01), Seiten 317-323, XP004085336 ISSN: 0921-5107
- PATENT ABSTRACTS OF JAPAN vol. 1999, no. 09, 30. Juli 1999 (1999-07-30) & JP 11 116398 A (SHOWA DENKO KK), 27. April 1999 (1999-04-27)

## Beschreibung

Die Erfindung betrifft eine Vorrichtung zur Herstellung mindestens eines SiC-Einkristalls. Die Herstellung erfolgt mittels eines Sublimationsprozesses in einem Tiegel.

Aus der *DE 32 30 727 C2* ist ein Verfahren und eine Vorrichtung zur Sublimationszüchtung eines SiC-Einkristalls bekannt. Dazu wird festes Siliciumcarbid (SiC), das sich in einem Vorratsbereich befindet, auf eine Temperatur zwischen 2000°C und 2500°C erhitzt und damit sublimiert. Eine durch die Sublimation entstehende SiC-Gasphase enthält als Komponenten unter anderem reines Silicium (Si) sowie die Carbidverbindungen Si₂C, SiC₂ und auch SiC. Das Gasgemisch dieser SiC-Gasphase diffundiert durch eine poröse Graphitwand in einen Reaktions- oder Kristallbereich, in dem sich ein SiC-Keimkristall befindet. Auf diesem kristallisiert Siliciumcarbid aus der SiC-Gasphase bei einer Kristallisationstemperatur zwischen 1900°C und 2000°C aus. In dem Kristallbereich befindet sich neben dem Gasgemisch der SiC-Gasphase auch ein Schutzgas, vorzugsweise Argon (Ar). Über eine entsprechende Einleitung dieses Argon-Gases wird ein im Kristallbereich gewünschter Druck zwischen 1 mbar und 5 mbar eingestellt. Der Gesamtdruck im Kristallbereich setzt sich aus dem Dampfpartialdruck der SiC-Gasphase und dem Dampfpartialdruck des Argon-Gases zusammen.

In der *WO 94*/*23096 A1* wird ein Verfahren und eine Vorrichtung zur Sublimationszüchtung nach dem modifizierten Lely-Verfahren beschrieben. Als besonderes Merkmal ist jeweils ein Gaskanal zwischen dem SiC-Vorratsbereich und dem Kristallbereich angeordnet. Dieser Gaskanal dient dabei insbesondere einer zielgerichteten Zuführung des sublimierten Gasgemisches der SiC-Gasphase zu dem SiC-Keimkristall im Kristallbereich.

Durch eine Anordnung mehrerer solcher Gaskanäle innerhalb eines Tiegels ist außerdem die gleichzeitige Herstellung mehrerer SiC-Einkristalle möglich. Eine der Tiegelinnenzone zugewandte Seite der Tiegelwände kann insbesondere auch mit einer vorzugsweise pyrolytisch erzeugten, hitzebeständigen Beschichtung versehen sein. Genaue Angaben über die Zusammensetzung und Wirkungsweise dieser Beschichtung werden in der WO 94/32096 nicht gemacht.

Siliciumcarbid ist eine inkongruent sublimierende oder verdampfende Verbindung aus Silicium und Kohlenstoff. Unter einer inkongruenten Verbindung versteht man eine Verbindung aus mindestens zwei Komponenten, wobei bei vorgegebener Temperatur eine der beiden Komponenten (=Silicium) einen höheren Dampfdruck aufweist als die andere (=Kohlenstoff). Somit sublimieren deutlich mehr Silicium-Atome als Kohlenstoff-Atome aus dem Vorrat aus festem SiC. Dies hat zur Folge, daß sich in dem Gasgemisch der SiC-Gasphase ein Überschuß an Silicium und in dem zurückbleibendem Vorrat ein Überschuß an Kohlenstoff einstellt. Man sagt auch, daß der Vorrat carbidisiert. Das Gasgemisch der SiC-Gasphase ist bei der Prozeßtemperatur von über 2000°C vor allem aufgrund der reinen Silicium-Komponente sehr aggressiv. Die mit einem hohen Uberschußanteil in der SiC-Gasphase vorhandenen Silicium-Atome neigen sehr stark zu einer Reaktion mit anderem im Tiegel vorhandenen Material, beispielsweise auch mit dem Material der Tiegelwand. Insbesondere wenn die Tiegelwand wie beim Stand der Technik aus Graphit besteht, geht ein Teil des Siliciums in der SiC-Gasphase durch Reaktion mit dem Kohlenstoff der Tiegelwand verloren. Ein weiterer Verlust an Silicium-Atomen ergibt sich durch Ausdiffundieren durch Poren in der Tiegelwand oder durch Fugen zwischen mechanisch separaten Tiegelelementen, aus denen der Tiegel zusammengesetzt ist. Dieser verlorengegangene Anteil an Silicium-Atomen steht dann jedoch nicht mehr für das Kristallwachstum des SiC-Einkristalls zur Verfügung. Das stöchiometrische Verhältnis zwischen Silicium und Kohlenstoff entspricht im Kristallbereich dadurch nicht dem für ein qualitativ hochwertiges Kristallwachstum benötigten Wert.

In der *WO 97*/*27350 A1* und in dem Aufsatz *Inst. Phys. Conf. Serial No. 142: Chapter 1, Silicon Carbide and Related Materials 1995 Conference, Kyoto, 1996 IOP Publishing Ltd., Selten 29 bis 32* wird ein Tiegel aus einem Tantal-Vollmaterial beschrieben. Da Tantal ein sehr hitzebeständiges und auch bei hohen Temperaturen chemisch stabiles Material ist, findet auch bei der Züchtungstemperatur von über 2000°C praktisch keine Reaktion zwischen dem Tantal der Tiegelwand und dem Silicium der aggressiven SiC-Gasphase statt, so daß diese Verlustquelle für das Silicium bei dem offenbarten Tantal-Tiegel entfällt. Weiterhin kommt es jedoch zu einem Verlust an Silicium-Atomen über die Fugen zwischen den einzelnen Tiegelelementen. Außerdem ist der offenbarte Tantal-Tiegel so klein, daß nur ein bis zu 3 mm langer SiC-Einkristall gezüchtet werden kann. Ein Tiegel aus Tantal-Vollmaterial ist darüber hinaus in der Herstellung sehr aufwendig und damit auch teuer.

Weitere Vorrichtungen zur Herstellung eines SiC-Einkristalls sind mit der *US 5,895,526* und mit dem *Patentabstract zur JP 10291899 A* offenbart. Außerdem werden in der *DE 36 44 746 A1* ein allgemeines Verfahren zur Züchtung eines Kristalls aus der Schmelze und eine hierfür einsetzbare Vorrichtung beschrieben.

Die Aufgabe der Erfindung besteht nun darin, eine Vorrichtung zur Herstellung mindestens eines SiC-Einkristalls anzugeben, die einen gegenüber dem Stand der Technik geringeren Verlust an Silicium-Atomen in der SiC-Gasphase aufweist und die sich insbesondere auch für die Züchtung eines längeren SiC-Einkristall als beim Stand der Technik eignet.

Zur Lösung der Aufgabe wird eine Vorrichtung entsprechend den Merkmalen des Patentanspruchs 1 angegeben.

Bei der erfindungsgemäßen Vorrichtung zur Herstellung mindestens eines SiC-Einkristalls handelt es sich um eine Vorrichtung, die mindestens
a) einen Tiegel mit einer Tiegelinnenzone,
   a1) die mindestens einen Vorratsbereich zur Aufnahme eines Vorrats aus festem SiC,
   und
   a2) mindestens einen Kristallbereich zur Aufnahme mindestens eines SiC-Keimkristalls, auf den der SiC-Einkristall aufwächst, enthält,
   wobei
   a3) der Tiegel auf einer der Tiegelinnenzone zugewandten Seite mit einer Folie ausgekleidet ist, die aus einem Material der Gruppe von Tantal, Wolfram, Niob, Molybdän, Rhenium, Iridium, Ruthenium, Hafnium und Zirkon oder aus einem Material mit wenigstens einem Element der Gruppe besteht,
   und
b) eine außerhalb des Tiegels angeordnete Heizeinrichtung umfaßt.

Die Erfindung beruht dabei auf der Erkenntnis, daß es bei der hohen Prozeßtemperatur während der Züchtung des SiC-Einkristalls zu einer Carbidisierung der zur Auskleidung des Tiegels verwendeten Folie kommt. Eine solche Carbidisierung ist mit einer Volumenänderung der Folie verbunden. Bei einer Folie wirkt sich diese Folienänderung im Gegensatz zu einer auf die äußere Tiegelwand fest aufgebrachten Beschichtung in einer Längen- und Dickenänderung aus. Insbesondere die Längenänderung der Folie kann dabei bis zu 10 % betragen. Demgegenüber würde eine fest auf die innere Tiegelwand aufgebrachte Beschichtung bei der Carbidisierung aufgrund der Haftung an der Tiegelwand in erster Linie in Dickenrichtung wachsen. Gerade die Längenänderung der Folie führt nun aber vorteilhafterweise zu einer Abdichtung von in der Tiegelwand vorhandenen Fugen oder Poren. Der Verschluß dieser undichten Stellen hat die positive Konsequenz, daß praktisch kein Silicium der SiC-Gasphase aus der Tiegelinnenzone hinausdiffundieren kann. Da das Material der Folie außerdem auch chemisch stabil gegenüber der aggressiven SiC-Gasphase ist und es zu keiner nennenswerten Reaktion mit der Silicium-Komponente der SiC-Gasphase kommt, sind somit beide Hauptverlustquellen für die Silicium-Atome in der SiC-Gasphase eliminiert. Ein wesentlicher Verlust an Silicium-Atomen tritt also nicht mehr auf.

Vielmehr wird der SiC-Gasphase im Zusammenhang mit der Carbidisierung der Folie ein geringer Anteil an Kohlenstoff-Atomen entzogen. Dies geschieht jedoch nur zu Beginn des Züchtungsprozesses und dauert solange, bis die Folie vollständig carbidisert ist. Der entzogene Kohlenstoffanteil ist außerdem so gering, daß er über die gesamte Prozeßdauer betrachtet, praktisch als vernachlässigbar anzusehen ist. Das Silicium-zu-Kohlenstoff-Verhältnis in der SiC-Gasphase wird also praktisch nicht beeinflußt und entspricht dann über die gesamte Prozeßdauer dem für ein qualitativ hochwertiges Kristallwachstum erforderlichen Wert.

Da kein wesentlicher Silicium-Verlust auftritt, bildet sich in der SiC-Gasphase ein quasi geschlossener Silicium-Kreislauf aus, bei dem den Silicium-Atomen die Eigenschaft eines Transportmediums zukommt. Dieser Silicium-Kreislauf läuft wie folgt ab:
Ein gasförmiges Si-Atom reagiert im Vorratsbereich mit einem aus dem festen SiC sublimierten SiC-Partikel und bildet dann eine gasförmige Si₂C-Verbindung, die z.B. durch Diffusion zum Kristallbereich transportiert wird. Dort erfolgt dann bei der kristallinen Abscheidung auf einer Kristallisationsoberfläche des aufwachsenden SiC-Einkristalls wieder die Auftrennung in ein Si-Atom und eine SiC-Verbindung, die zum Kristallwachstum des SiC-Einkristalls beiträgt. Das verbleibende freie Si-Atom gelangt dann beispielsweise über Diffusions- oder Konvektionsmechanismen wiederum zum Vorrat aus festem SiC zurück und kann dort eine neue Si₂C-Verbindung eingehen, womit der Kreislauf geschlossen ist.

Da abgesehen von dem anfänglichen inkongruenten Sublimieren bis zur Einstellung des üblichen Si-Überschusses in der SiC-Gasphase im weiteren Verlauf der Sublimationszüchtung jeweils gleich viele Silicium- und Kohlenstoff-Atome dem Vorrat entnommen werden, stellt sich auch die im Stand der Technik übliche Carbidisierung des Vorrats nicht mehr ein. Dadurch steigt die Ergiebigkeit des Vorrats aus festem SiC.

Die zur Auskleidung verwendete Folie kann auch bereits vor Beginn des Züchtungsprozesses schon eine gewisse Teilcarbidisierung aufweisen. Solange die Restcarbidisierung mit einer noch ausreichend großen Längenänderung zur vollständigen Abdichtung der Poren und Fugen in der Wand des Tiegels ausreicht, ist eine solche Teilcarbidisierung der Folie jedoch ohne weiteres möglich. Die Auskleidung ist nicht unbedingt in der gesamten Tiegelinnenzone vorhanden. Es ist auch möglich, daß die Auskleidung nur in dem Kristallbereich und dem Bereich, in dem der Materialtransport des sublimierten Gasgemischs zum SiC-Einkristall erfolgt, vorhanden ist. Der Tiegel kann aber auch komplett ausgekleidet sein.

Die Folienauskleidung bietet gegenüber einem Tiegel aus Tantal-Vollmaterial außerdem weitere Vorteile. Im Gegensatz zu einem Vollmaterial-Tiegel aus Tantal ist eine Folie nämlich leicht und auch preiswert herzustellen. Die Auskleidung des Tiegels erfolgt dann einfach dadurch, daß die Folie lose an die Tiegelinnenwände angelegt wird. Eine besondere Befestigung der Folie an den Tiegelinnenwänden ist nicht erforderlich. Die Tiegelgröße ist damit auch nicht wie bei dem Vollmaterial-Tiegel aus Tantal begrenzt. Sie wird vielmehr durch den auszukleidenden Tiegel bestimmt, der insbesondere in beliebiger räumlicher Geometrie und Größe vorliegen kann. Eine entsprechende Folienauskleidung ist nachträglich stets möglich. Damit läßt sich aber auch ein wesentlich größerer SiC-Einkristall als beim Stand der Technik züchten. Die geringe Baugröße des Vollmaterial-Tiegels aus Tantal beschränkt nämlich auch die mögliche Länge des zu züchtenden SiC-Einkristalls auf einen entsprechend kleinen Wert.

Besondere Ausgestaltungen der Vorrichtung ergeben sich aus den abhängigen Unteransprüchen.

Vorteilhaft ist eine Ausführungsform, bei der die Folie bis zu 200 µm dick ist. Eine solche Folie läßt sich einfach herstellen und auch ohne Probleme als Auskleidung in die Tiegelinnenzone einbringen. Insbesondere ist eine solche Folie erheblich preiswerter als ein Tiegel aus einem Vollmaterial mit den gleichen Eigenschaften wie das Material der Folie. Typischerweise liegt die Dicke der verwendeten Folie bei 50 µm.

Vorteilhaft ist außerdem eine Ausgestaltung, bei der der Tiegel zumindest weitgehend aus Graphit besteht. Da bereits die Folienauskleidung sowohl eine chemische Reaktion der Tiegelwände mit den Komponenten der SiC-Gasphase verhindert als auch den Tiegel abdichtet, sind an die von der Tiegelinnenzone abgewandten Bereiche der Tiegelwände diesbezüglich keine weiteren Forderungen zu stellen. Ohne weiteres kann für diese Bereiche des Tiegels das vergleichsweise kostengünstig und einfach herzustellende Graphit verwendet werden. Da Graphit außerdem einen höheren spezifischen elektrischen Widerstand als Tantal besitzt, wird mit einer induktiven Heizeinrichtung eine größere Eindringtiefe in einer Graphitwand als in einer Tantalwand erreicht. Dadurch wird eine Graphitwand homogener aufgeheizt als eine Tantalwand. Verglichen mit einem Tantal-Tiegel ergibt sich damit auch insgesamt eine homogenere Aufheizung eines im wesentlichen aus Graphit hergestellten Tiegels. In dem Tiegel kann neben der Folienauskleidung auch noch mindestens ein weiteres Element aus einem von Graphit verschiedenen Material, beispielsweise aus Glaskohle, vorhanden sein. Ein solches weiteres Element kann z.B. ein zur Gasführung verwendeter Einsatz aus Glaskohle sein.

Vorteilhaft ist eine weitere Ausgestaltung, bei der die im Außenbereich des Tiegels angeordnete Heizeinrichtung induktiv realisiert ist. Es hat sich nämlich gezeigt, daß eine induktive Heizeinrichtung insbesondere bei der für die Sublimationszüchtung benötigten hohen Prozeßtemperatur von über 2000°C besser geeignet ist als eine ebenfalls prinzipiell mögliche Widerstandsheizung. Bei einer Widerstandsheizung kann insbesondere bei der hohen Prozeßtemperatur eine Degradation des Widerstandsheizelements auftreten. Das Widerstandsheizelement hat somit nur eine begrenzte Lebensdauer und muß in zyklischen Abständen ausgetauscht werden. Dies verursacht unerwünschten Zusatzaufwand und -kosten, die bei einer induktiven Heizeinrichtung nicht anfallen, da kein vergleichbares Verschleißteil enthalten ist.

Die Heizeinrichtung kann auch mehrteilig ausgeführt sein. Insbesondere kann jedem Bereich des Tiegels ein separat steuerbarer Teil der Heizeinrichtung zugeordnet sein. Damit läßt sich dann die Temperatur im Kristallbereich weitgehend unabhängig von der im Vorratsbereich steuern.

Bei einer weiteren vorteilhaften Ausgestaltung ist der Tiegel doppelwandig ausgebildet. Die doppelwandige Ausgestaltung bietet insbesondere bei dem Einsatz einer induktiven Heizeinrichtung Vorteile. Eine Doppelwand bewirkt nämlich eine Homogenisierung der zwischen dem Vorratsbereich und dem Kristallbereich in der Tiegelinnenzone verlaufenden Temperaturverteilung, die sich in der äußeren Tiegelwand aufgrund der induzierten Ströme einstellt. Die induktive Heizeinrichtung heizt den Tiegel durch Induktion eines hohen elektrischen Stroms in der äußeren Tiegelwand auf. Dabei entstehen im Bereich der induzierten elektrischen Ströme lokale Maxima in der Temperaturverteilung. Durch eine zusätzlich vorgesehene thermische Ankopplung der inneren Tiegelwand an die äußere Tiegelwand gleichen sich diese Schwankungen in der Temperaturverteilung aus. In der Tiegelinnenzone erhält man damit den gewünschten homogenen Verlauf des Temperaturgradienten.

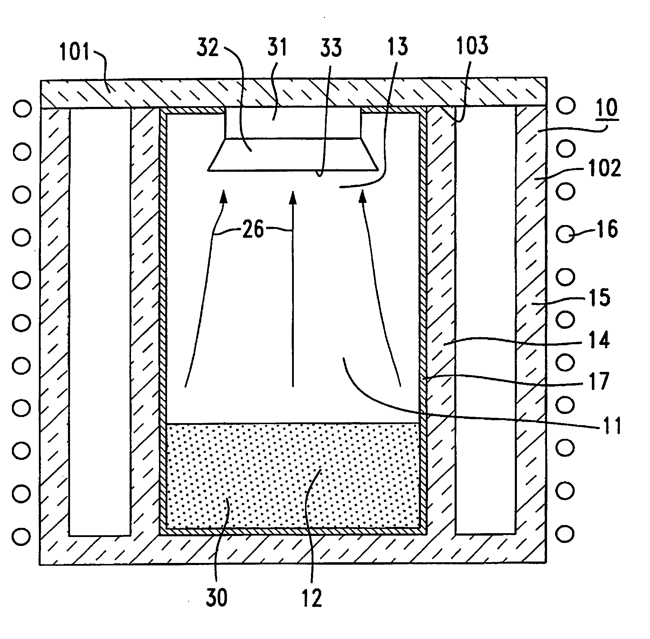

Ein bevorzugtes Ausführungsbeispiel wird nunmehr anhand der einzigen Figur der Zeichnung näher erläutert. Zur Verdeutlichung ist die Zeichnung nicht maßstäblich ausgeführt und gewisse Merkmale sind schematisiert dargestellt. In der Figur ist eine Vorrichtung zur Züchtung eines SiC-Einkristalls in einem folienausgekleideten Tiegel gezeigt.

Die in der Figur in Schnittdarstellung gezeigte Vorrichtung dient der Sublimationszüchtung eines SiC-Einkristalls 32, der insbesondere in Form eines Volumeneinkristalls auf einem SiC-Keimkristall 31 aufwächst. Für die Sublimationszüchtung wird ein Tiegel 10 mit einer Tiegelinnenzone 11 eingesetzt. Das Kristallwachstum findet dann in einem Kristallbereich 13 des Tiegels 10 statt. Der SiC-Keimkristall 31 ist an einem Tiegeldeckel 101 des Tiegels 10 befestigt. In einem Tiegeltopf 102 befindet sich in einem Vorratsbereich 12 ein Vorrat aus festem SiC 30, das bei einer Prozeßtemperatur von über 2000°C sublimiert wird. Dadurch entsteht eine SiC-Gasphase, die als Gasspezies mindestens die Komponenten Si, Si₂C, SiC₂ und SiC enthält. Die Komponenten der SiC-Gasphase werden durch einen Gasfluß 26 vom Vorratsbereich 12 zum Kristallbereich 13 transportiert und kristallisieren hier an einer Kristallisationsoberfläche 33 des aufwachsenden SiC-Einkristalls 32 aus.

Das feste SiC 30 im Vorratsbereich 12 kann sowohl aus einem kompakten SiC-Materialblock, insbesondere aus gesintertem SiC, oder auch aus pulverförmigem, polykristallinem SiC bestehen.

Der Gasfluß 26 kann auch gezielt auf die Kristallisationsoberfläche 33 gerichtet werden. Ein an der Kristallisationsoberfläche 33 vorliegender Konzentrationsverlauf der über den Gasfluß 26 zugeführten Komponenten der SiC-Gasphase kann sowohl als homogener Verlauf als auch als Verlauf mit einem vorgegebenen Profil ausgebildet werden. Insbesondere kann im Randbereich der Kristallisationsoberfläche 33 eine höhere Konzentration an Komponenten der SiC-Gasphase zur Verfügung gestellt werden als im Zentrum der Kristallisationsoberfläche 30. Dadurch wird der inhomogene Temperaturverlauf, der im Zentrum der Kristallisationsoberfläche 33 eine niedrigere Temperatur als im Randbereich aufweist, ausgeglichen. Man erhält dann anstelle der sonst üblichen konvexen Wachstumsphasengrenze eine praktisch planare Wachstumsphasengrenze. Dies steigert die Ausbeute und die Kristallqualität.

Der Tiegel 10 wird mittels einer induktiven Heizeinrichtung 16 auf die Prozeßtemperatur aufgeheizt. Durch die doppelwandige Ausführung mit einer inneren und einer äußeren Tiegelwand 14 bzw. 15 erreicht man in der Tiegelinnenzone 11 einen homogenen Verlauf des Temperaturgradienten zwischen dem Vorratsbereich 12 und dem Kristallbereich 13.

Der Tiegel 10 besteht aus mindestens zwei mechanisch voneinander unabhängigen Tiegelelementen, dem Tiegeltopf 102 und dem Tiegeldeckel 101. Der Tiegeldeckel 101 wird auf das Tiegeltopf 102 gesetzt und verschließt dieses. An einer Kontaktfläche zwischen dem Tiegeldeckel 101 und dem Tiegeltopf 102 ergibt sich jedoch eine Fuge 103, die insbesondere durchlässig für die Silicium-Atome der SiC-Gasphase ist. Deshalb befindet sich auf einer der Tiegelinnenzone 11 zugewandten Seite einer Tiegelwand eine Folienauskleidung 17. Die Folienauskleidung 17 besteht aus einer Tantal-Folie mit einer Dicke von etwa 50 µm. Bei der Prozeßtemperatur von über 2200°C carbidisiert die Tantal-Folie noch vor oder gleich zu Beginn der Züchtung des SiC-Keimkristalls und dehnt sich dabei um bis zu 10 % in ihrer Länge aus. Diese Längenänderung bewirkt dann eine Abdichtung des Tiegels 10, so daß praktisch kein Silicium der SiC-Gasphase die Tiegelinnenzone 11 durch die Fuge 103 oder auch durch nicht dargestellte Poren in der Tiegelwand verlassen kann. Das Tantal und auch das sich bildende Tantalcarbid der Folienauskleidung 17 sind außerdem bei der Prozeßtemperatur während der Kristallzüchtung chemisch stabil gegenüber der aggressiven SiC-Gasphase, so daß es zu praktisch keiner relevanten Reaktion mit den Silicium-Atomen der SiC-Gasphase kommt. Damit können der SiC-Gasphase Silicium-Atome weder über ein Hinausdiffundieren noch durch eine chemische Reaktion verlorengehen. Dies wirkt sich günstig auf ein Kristallwachstum mit hoher Qualität aus.

Der in der Figur dargestellte Tiegel 10 ist für die Züchtung eines einzigen SiC-Einkristalls 32 ausgelegt. Ebensogut gibt es jedoch andere Ausführungsformen für den Tiegel 10, der auch die gleichzeitige Züchtung mehrerer SiC-Einkristalle zuläßt.

Der Polytyp des gezüchteten SiC-Einkristalls 32 ist prinzipiell beliebig. Mit der Vorrichtung lassen sich alle gängigen SiC-Polytypen wie z.B. 4H-SiC, 6H-SiC oder 15R-SiC herstellen. Auch kubisches SiC vom 3C-SiC-Polytyp kann gezüchtet werden.

## Patentansprüche

1. Vorrichtung zur Herstellung mindestens eines SiC-Einkristalls (32) umfassend mindestens
a) einen Tiegel (10) mit einer Tiegelinnenzone (11),
a1) die mindestens einen Vorratsbereich (12) zur Aufnahme eines Vorrats aus festem SiC (30)
und
a2) mindestens einen Kristallbereich (13) zur Aufnahme mindestens eines SiC-Keimkristalls (31) , auf den der SiC-Einkristall (32) aufwächst, enthält,
wobei
a3) der Tiegel (11) auf einer der Tiegelinnenzone (11) zugewandten Seite mit einer Folie (17) ausgekleidet ist, die aus einem Material der Gruppe von Tantal, Wolfram, Niob, Molybdän, Rhenium, Iridium, Ruthenium, Hafnium und Zirkon oder aus einem Material mit wenigstens einem Element der Gruppe besteht,
und
b) eine außerhalb des Tiegels (10) angeordnete Heizeinrichtung (16).

2. Vorrichtung nach Anspruch 1, **dadurch gekennzeichnet, daß** die Folie (17) eine Dicke von bis zu 200 µm aufweist.

3. Vorrichtung nach Anspruch 1 oder 2, **dadurch gekennzeichnet, daß** der Tiegel (10) zumindest weitgehend aus Graphit besteht.

4. Vorrichtung nach einem der vorhergehenden Ansprüche **gekennzeichnet durch** eine induktive Heizeinrichtung (16).

5. Vorrichtung nach einem der vorhergehenden Ansprüche, **dadurch gekennzeichnet, daß** der Tiegel (10) doppelwandig ausgeführt ist.

## Claims

1. Device for producing at least one SiC single crystal (32), comprising at least
a) a crucible (10) having a crucible inner zone (11),
a1) which contains at least one storage area (12) for holding a stock of solid SiC (30)
and
a2) at least one crystal area (13) for holding at least one SiC seed crystal (31), onto which the SiC single crystal (32) grows,
whereby
a3) the crucible (11), on a side that faces the crucible inner zone (11), is lined with a foil (17) consisting of a material in the group comprising tantalum, tungsten, niobium, molybdenum, rhenium, iridium, ruthenium, hafnium and zirconium, or of a material containing at least one element in the group,
and
b) a heater device (16) located outside the crucible (10).

2. Device according to Claim 1, **characterised in that** the foil (17) has a thickness of up to 200 µm.

3. Device according to Claim 1 or 2, **characterised in that** the crucible (10) is at least substantially made from graphite.

4. Device according to one of the preceding claims, **characterised by** an inductive heater device (16).

5. Device according to one of the preceding claims, **characterised in that** the crucible (10) has a double-walled design.

## Revendications

1. Dispositif de production d'un monocristal (32) de SiC comprenant au moins
b) un creuset (10) ayant une zone (11) intérieure de creuset,
a1) qui comprend au moins une partie (12) de réserve de réception d'une réserve SiC (30) solide
et
a2) au moins une partie (13) de cristal de réception d'au moins un cristal (31) germe de SiC, sur lequel croît le monocristal (32) de SiC,
dans lequel
a3) le creuset (11) est revêtu, sur un côté tourné vers la zone (11) intérieure du creuset, d'un film (17) qui est en une matière choisie dans le groupe du tantale, du tungstène, du niobium, du molybdène, du rhénium, de l'iridium, du ruthénium, de l'hafnium et du zirconium, ou en une matière ayant au moins l'un des éléments du groupe,
et
b) un dispositif (16) de chauffage disposé à l'extérieur du creuset (10).

2. Dispositif suivant la revendication 1, **caractérisé en ce que** le film (17) a une épaisseur allant jusqu'à 200 µm.

3. Dispositif suivant la revendication 1 ou 2, **caractérisé en ce que** le creuset (10) est constitué au moins dans une grande mesure de graphite.

4. Dispositif suivant l'une des revendications précédentes, **caractérisé par** un dispositif (16) de chauffage par induction.

5. Dispositif suivant l'une des revendications précédentes, **caractérisé en ce que** le creuset (10) est à double paroi.
